# EUROPEAN PATENT APPLICATION

(11) **EP 2 357 663 A2**
(43) Date of publication of application: **17.08.2011**
(21) Application number: 09824963.4
(22) Date of filing: 03.11.2009
(51) Int. Cl.: H01L 21/302, H01L 21/306

(54) **APPARATUS AND METHOD FOR WET-PROCESSING OBJECT, AND FLUID DIFFUSION PLATE AND BARREL USED THEREIN**

(30) Priority: 04.11.2008 KR 20080108937; 28.10.2009 KR 20090102899
(71) Applicant: Siltron Inc., Gumi-si, Gyeonbuk 730-724 (KR)
(72) Inventor: CHOI, Eun-Suck, Yeongi-gun Chungcheongnam-do 339-805 (KR); YI, Jae-Hwan, Gumi-si Gyeongbuk 730-772 (KR); KIM, Bong-Woo, Gumi-si Gyeongbuk 730-712 (KR); YU, Hwan-Su, Daegu 702-737 (KR); AHN, Jin-Woo, Daejeon 302-814 (KR)
(74) Representative: Leszczynski, André
(86) International application number: PCT/KR2009/006402
(87) International publication number: WO 2010/053280

(57) **Abstract**

An apparatus for wet treatment of an object includes a treatment bath in which an object to be treated is received and treated; a plurality of object supporting rods rotatably installed in the treatment bath and having a plurality of slots formed in surfaces thereof to support an object so that the object stands in a direction perpendicular to a bottom surface of the treatment bath; and a rotating means connected to the object supporting rods to rotate the object in a circumferential direction by rotating the object supporting rods. Treatment fluid injecting holes for injecting a treatment fluid to the object and treatment fluid channels for supplying the treatment fluid to the treatment fluid injecting holes are formed in the object supporting rods. Thus, a dead zone in the treatment bath is removed and the treatment fluid may flow uniformly and smoothly, which improves treatment efficiency and treatment uniformity.

## Description

### TECHNICAL FIELD

The present invention relates to an apparatus and method for wet treatment (e.g., cleaning or etching) of an object such as a wafer.

### BACKGROUND WART

Generally, a series of processes including a slicing process, a grinding process, a lapping process, an etching process and a polishing process are performed to produce a wafer for making a semiconductor device. During the above processes, the surface of the wafer is contaminated with various contaminants. The representative contaminants are fine particles, metallic contaminants, organic contaminants, and so on. These contaminants deteriorate the quality of the wafer. In addition, the contaminants become factors of causing physical defects and characteristic deterioration of a semiconductor device, which result in the deterioration of a production yield of semiconductor devices. To remove such contaminants, a wet cleaning process using an acid or alkali etching fluid or a deionized water is generally performed. In addition, in the manufacturing process of the wafer or the semiconductor device, various kinds of etching processes are included. For example, the wafer is put into an etching bath and wet-etched using an etching solution.

As the rules of design are becoming stricter these days, higher cleanness and flatness are demanded for the entire surface of a wafer. In addition, uniform cleanness and flatness are demanded in one sheet of wafer. Moreover, the uniform cleanness and flatness are also demanded among wafers in a case where a plurality of wafers are put into a cleaning or etching bath and then treated therein in a batch. In this regard, Korean Laid-open Patent Publication No. 2005-0002532 and Japanese Laid-open Patent Publication No. 2006-032640 disclose a method for cleaning or etching a wafer while rotating the wafer by supporting the wafer on a bar-type support and rotating the support. Korean Laid-open Patent Publication No. 2005-0059895 discloses a method for cleaning a wafer by installing a separate ultra deionized water injecting pipe. In addition, Korean Laid-open Patent Publication No. 2003-0054732 discloses an etching device for etching a wafer while supplying gas by disposing a pipe with a gas discharging hole below a carrier to which a plurality wafer is supported to stand thereon. Korean Laid-open Patent Publication No. 2003-0056702 discloses an etching device including a gas supply pipe and a plurality of diffusion plates which have a plurality of holes and are arranged at upper and lower locations with a gap between them so that an etching solution supplied from an inner bottom of a treatment bath diffuses to the entire area in the treatment bath.

However, according to conventional techniques, a dead zone may be generated in the treatment bath where a cleaning or etching fluid may not flow easily or stop. In the dead zone, impurities or byproducts generated during a cleaning or etching process may remain. These impurities or byproducts may become a source of pollution which is absorbed to the wafer again to contaminate the wafer. In particular, in a process with a rapid etching speed, the impurities or byproducts may act as a main factor producing many irregular wafers. This problem has become more serious as the rules of design have gotten stricter these days.

In particular, in a case where an ultra-deionized water injecting pipe is installed around a wafer, the ultra-deionized water is injected in only one direction, and for this reason, a dead zone may remain in a direction opposite to the injecting direction. To prevent this problem, several injecting pipes should be installed in the cleaning bath, which then causes a problem of making the device huge and complicating and also acts as another source of pollution.

Moreover, in a case where a gas supply pipe or tube is installed below the carrier, the gas cannot be sufficiently supplied to a region at a long distance. This may deteriorate the uniformity of cleanness or etching, particularly in a case where a large-scale wafer is treated. In addition, in a case where a plurality of diffusion plates are installed, the volume of the device is increased, and an etching fluid may be interfered by the flow of gas, which may disturb the smooth and uniform flow of the etching fluid and the gas.

### DISCLOSURE

### Technical Problem

The present invention is designed to solve the problems of the prior art, and therefore it is an object of the present invention to provide a fluid diffusion plate and barrel having improved treatment efficiency and uniformity by removing a dead zone in a treatment bath and allowing a treatment fluid to flow smoothly and uniformly. The present invention is also directed to providing an apparatus and method for wet treatment of an object using the fluid diffusion plate or barrel.

### Technical Solution

In one aspect, the present invention provides a fluid diffusion plate used in an apparatus for wet treatment of an object, the fluid diffusion plate including: an inner space defined by an upper surface, a lower surface and side surfaces; and a fluid supply unit for supplying a treatment fluid to the inner space, wherein a plurality of through holes are formed through the upper surface and the lower surface so that the through holes are isolated from the inner space by a barrier, and wherein a plurality of fluid discharging holes communicated with the inner space through the upper surface are formed in a portion of the upper surface where the through holes are not formed.

In another aspect, the present invention provides a barrel, which includes: a plurality of object supporting rods arranged in parallel with each other, a plurality of slots formed in surfaces of the object supporting rods so that objects to be treated with a flat plate shape are mounted to stand thereon in a direction perpendicular to a length direction thereof; both side plates for rotatably fixing both ends of the plurality of object supporting rods, respectively; and a rotating means for rotating the object by rotating the object supporting rods, wherein treatment fluid injecting holes for injecting a treatment fluid to the object and treatment fluid channels for supplying the treatment fluid to the treatment fluid injecting holes are formed in the object supporting rods.

In still another aspect, the present invention provides an apparatus for wet treatment of an object, which includes: a treatment bath in which an object to be treated is received and treated; an object supporting means for receiving and supporting the object to be treated; a treatment fluid supplying means for supplying a treatment fluid from a location below the treatment bath; and a fluid diffusion plate defined in claim 1, which is disposed between the object supporting means and the treatment fluid supplying means.

In further another aspect, the present invention provides an apparatus for wet treatment of an object, which includes: a treatment bath in which an object to be treated with a flat plate shape is received and treated; a barrel defined above and serving as an object supporting means for receiving and supporting the object to be treated; and a treatment liquid supply means for supplying the treatment liquid at a lower portion of the treatment bath.

In another aspect, the present invention provides an apparatus for wet treatment of a wafer, which includes: a treatment bath in which a wafer to be treated is received and treated; a plurality of wafer supporting rods rotatably installed in the treatment bath and having a plurality of slots formed in surfaces thereof to support a wafer so that the wafer stands in a direction perpendicular to a bottom surface of the treatment bath; and a rotating means connected to the wafer supporting rods to rotate the wafer in a circumferential direction by rotating the wafer supporting rods, wherein treatment fluid injecting holes for injecting a treatment fluid to the wafer and treatment fluid channels for supplying the treatment fluid to the treatment fluid injecting holes are formed in the wafer supporting rods.

In still another aspect, the present invention provides a method for wet treatment of an object in a treatment bath, wherein a treatment liquid and a treatment fluid are diffused below the object in the treatment bath and then supplied, so that the flow of the diffusing treatment liquid is not interfering with the flow of the diffusing treatment fluid.

In further another aspect, the present invention provides a method for wet treatment of a wafer, which includes: mounting a plurality of wafers to a plurality of wafer supporting rods which are rotatable and are disposed in parallel with each other in a treatment bath so that the wafers are parallel with each other in a length direction of the wafer supporting rods; and injecting a treatment fluid to the wafers while rotating the wafers in a circumferential direction by rotating the wafer supporting rods so that the wafers are treated, wherein, in the step of treating the wafers, the treatment fluid is supplied through treatment fluid channels formed in the wafer supporting rods, and the treatment fluid is injected to the wafers through treatment fluid injecting holes formed in surfaces of the wafer supporting rods.

### Advantageous Effects

According to the present invention, a treatment liquid and a treatment fluid may be diffused and supplied from a location below an object treated in a treatment bath so that the treatment liquid and the treatment fluid are not interfering with each other. Therefore, a dead zone in the treatment bath is eliminated and the flow of fluid becomes uniform. For this reason, it is possible to prevent impurities or etching byproducts from being absorbed again to the object treated, and to ensure uniform treatment. In addition, according to the present invention, the treatment liquid and the treatment fluid may be diffused and supplied together with just one diffusion plate. For this reason, the apparatus for wet treatment may be produced by a compact design.

### DESCRIPTION OF DRAWINGS

Other objects and aspects of the present invention will become apparent from the following description of embodiments with reference to the accompanying drawings in which:
Fig. 1 is a schematic view showing an apparatus for wet treatment of a wafer according to one embodiment of the present invention;
Fig. 2 is a schematic view showing a wafer supporting rod to which wafers are mounted, in the apparatus of Fig. 1;
Fig. 3 is a partially enlarged view showing a part of Fig. 2;
Fig. 4 is a sectional view taken along the line A-A' of Fig. 2 according to one example;
Fig. 5 is a sectional view taken along the line A-A' of Fig. 2 according to another example;
Fig. 6 is a partially enlarged view showing a part of Fig. 5;
Fig. 7 is a schematic view showing that the apparatus for wet treatment of a wafer according to one embodiment of the present invention treats a wafer while injecting a treatment fluid;
Fig. 8 is a schematic view showing an apparatus for wet treatment of a wafer according to another embodiment of the present invention;
Fig. 9 is a schematic view showing a barrel to which wafers are mounted, in the apparatus of Fig. 8;
Fig. 10 is a left side view showing the barrel of Fig. 9;

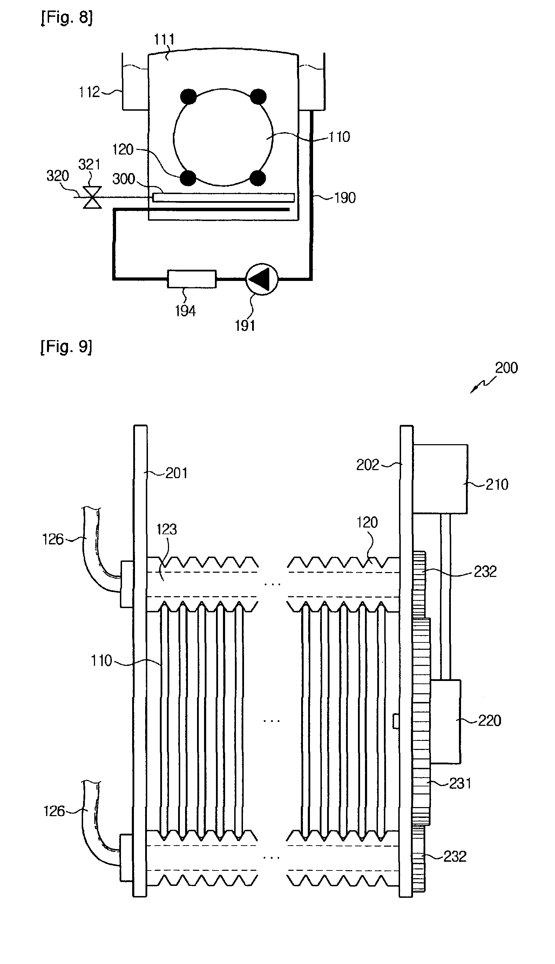

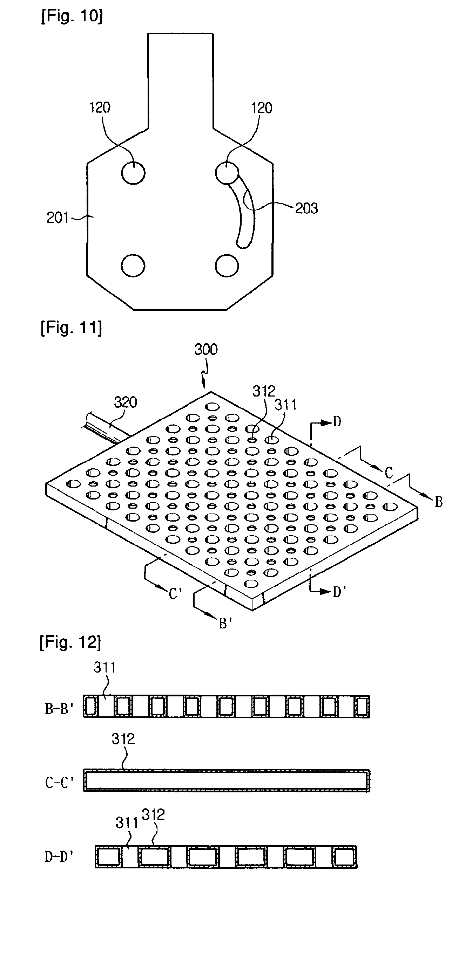

Fig. 10 is a left side view showing the barrel of Fig. 9;
Fig. 11 is a perspective view showing a diffusion plate used in the apparatus of Fig. 8; and
Fig. 12 are sectional views taken along the lines B-B', C-C' and D-D' of Fig. 11.

### BEST MODE

Hereinafter, preferred embodiments of the present invention will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation. Therefore, the description proposed herein is just a preferable example for the purpose of illustrations only, not intended to limit the scope of the invention, so it should be understood that other equivalents and modifications could be made thereto without departing from the spirit and scope of the invention.

In addition, though it is assumed in the following description that an object to be treated is a semiconductor wafer and that wet treatment is cleaning and etching, the present invention may also be applied to an article with a flat plate shape such as a glass substrate and to other kinds of wet treatment, without being limited to the above.

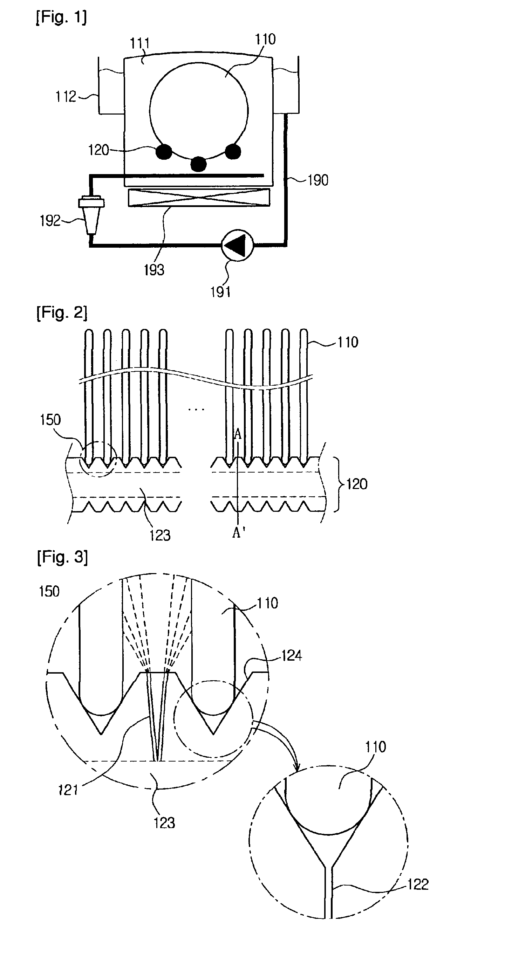

Fig. 1 is a schematic view showing an apparatus for cleaning a wafer according to one embodiment of the present invention.

Referring to Fig. 1, the apparatus for cleaning a wafer according to this embodiment includes a cleaning bath in which a cleaning liquid and a wafer 110 to be cleaned are received, a wafer supporting rod 120 supporting the wafer 110, a circulating pump 191 and a filter 192,

The cleaning bath may include an inner bath 111 in which the cleaning liquid and the wafer 110 are received, and an outer bath 112 for allowing a cleaning liquid overflowing from the inner bath 111 to circulate. The inner bath 111 is filled with a cleaning liquid such as an ultra-deionized water or an ozone water. The outer bath 112 is installed to an outer side of an upper portion of the inner bath 111 to receive the cleaning liquid overflowing over both side walls of the inner bath 111. The overflowing cleaning liquid is supplied to the inner bath 111 again through a circulating pipe 190 by means of a circulating pump 191. At this time, contaminants included in the overflowing cleaning liquid may be removed through a filter 192. However, it is also possible that the overflowing cleaning liquid is not circulated but drained. Further, it is also possible that the cleaning bath includes only the inner bath 111, without installing a separate outer bath 112 thereto.

In addition, the apparatus for cleaning a wafer according to one embodiment of the present invention may further include a megasonic oscillator 193. The megasonic oscillator 193 applies megasonic energy to the surface of the wafer 110 so as to enhance a cleaning efficiency while a cleaning process progresses. If the megasonic energy is applied as mentioned above, cavitation effects may be obtained at a low-frequency region, and acoustic streaming effects may be obtained at a high-frequency region.

The wafer supporting rod 120 supports a plurality of wafers 110 installed in parallel with each other in the cleaning bath so that the wafers 110 stand on the bottom surface of the cleaning bath. Fig. 2 is a schematic view showing the wafer supporting rod 120 to which the wafers 110 are mounted, and Fig. 3 is a partially enlarged view showing a part 150 of Fig. 2. Referring to Figs. 2 and 3, a cleaning liquid injecting hole and a cleaning liquid channel 123 are formed in the wafer supporting rod 120 connected to a rotating means (not shown).

The rotating means is a means for rotating the wafer 110 in a circumferential direction. The rotating means may be a driving shaft connected to the wafer supporting rod 120, but the present invention is not limited thereto. In a case where the rotating means is a driving shaft connected to the wafer supporting rod 120, the wafer supporting rod 120 may be connected to an external driving shaft to rotate in a clockwise or counterclockwise direction, which makes the wafer 110 mounted to a slot 124 formed in the wafer supporting rod 120 rotate. As described above, in the present invention, the wafer 110 may be cleaned while being rotated by the rotating means connected to the wafer supporting rod 120. Therefore, the wafer 110 may be cleaned uniformly.

The cleaning liquid injecting hole is a passage through which a cleaning liquid may be injected to the cleaning bath. The wafer supporting rod 120 may have one or more injecting holes. Preferably, the cleaning liquid injecting hole includes a first cleaning liquid injecting hole 121 formed between two adjacent slots 124 formed in the wafer supporting rod 120. Here, the slots 124 of the wafer supporting rod 120 allows the wafer 110 to be directly mounted to the wafer supporting rod 120 as shown in Fig. 3. If a cleaning liquid is injected through the first cleaning liquid injecting hole 121 while rotating the wafers 110 by the connecting means connected to the wafer supporting rod 120, the flow rate between the wafers 110 is accelerated to improve the cleaning efficiency. In addition, as the cleaning efficiency is improved, the time taken for cleaning may be resultantly shortened. Referring to Fig. 3, the first cleaning liquid injecting hole 121 may have two injecting holes between two adjacent slots so that the cleaning liquid may be injected to two wafers 110 at both sides together. However, the present invention is not limited thereto, and the first cleaning liquid injecting hole 121 may have one injecting hole or three or more injecting holes between two adjacent slots.

More preferably, the cleaning liquid injecting hole further includes a second cleaning liquid injecting hole 122 formed in the slot 124 of the wafer supporting rod 120. Referring to Fig. 3, the second cleaning liquid injecting hole 122 is illustrated to have one injecting hole per one slot 124. However, the second cleaning liquid infecting hole 122 may have a plurality of injecting holes.

The cleaning liquid channel 123 is a moving passage through which a cleaning liquid is supplied to the cleaning liquid injecting hole. Preferably, the cleaning liquid channel 123 is formed in the wafer supporting rod 120.

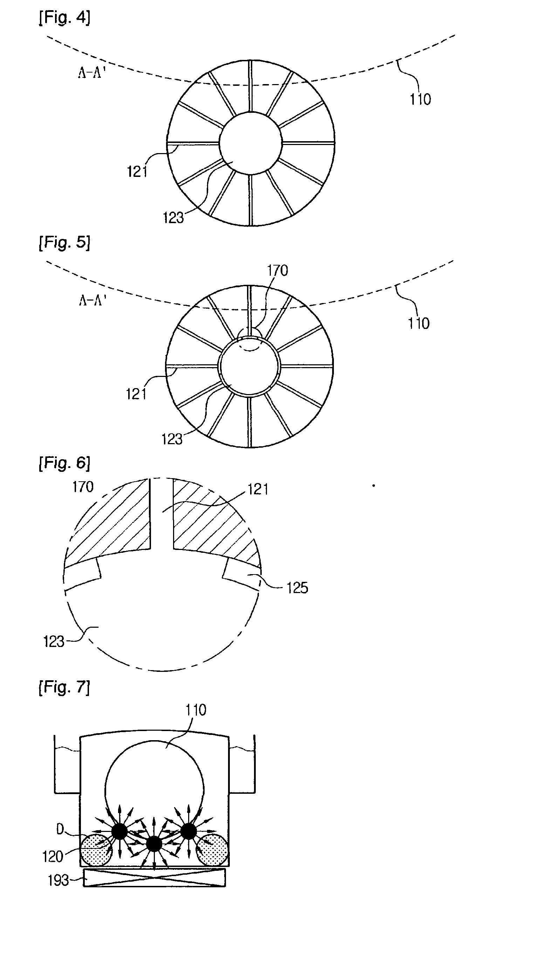

Fig. 4 is a sectional view taken along the line A-A' of Fig. 2. Referring to Fig. 4, the cleaning liquid channel 123 and a plurality of cleaning liquid injecting holes 121 for injecting a cleaning liquid are formed in the wafer supporting rod 120 according to one embodiment of the present invention. As shown in Fig. 4, the cleaning liquid injecting holes 121 are formed in a radial direction based on the cleaning liquid channel 123. Therefore, the cleaning liquid flowing through the cleaning liquid channel 123 may be injected in a radial direction through the cleaning liquid injecting holes 121. At this time, the number of cleaning liquid injecting holes 121 may be increased or decreased as necessary.

Fig. 5 is a sectional view taken along the line A-A' of Fig. 2 according to another example. Fig. 6 is a partially enlarged view showing a part 170 of Fig. 5, Referring to Figs. 5 and 6, the cleaning liquid channel 123 includes an outer wall 125 that is partially opened. The outer wall 125 of the cleaning liquid channel 123 is fixed. In addition, a region of the wafer supporting rods 120 other than the outer wall 125 of the cleaning liquid channel 123 as well as the cleaning liquid injecting holes 121 is rotatable. It is also possible that the outer wall 125 of the cleaning liquid channel 123 is rotatable and the region of the wafer supporting rod 120 other than the outer wall 125 of the cleaning liquid channel 123 is fixed, contrary to the above. Since the outer wall 125 of the cleaning liquid channel 123 is just partially opened, the cleaning liquid may be injected only when the cleaning liquid reaches the opened portion of the outer wall 125 of the cleaning liquid channel 123. Meanwhile, an amount or direction of cleaning liquid injected through the cleaning liquid injecting holes may be controlled by adjusting the number or direction of the open portions of the outer wall 125 of the cleaning liquid channel 123.

Fig. 7 shows an injecting state of the cleaning liquid by the apparatus for cleaning a wafer according to one embodiment of the present invention. Referring to Fig. 7, in a case of a general cleaning device, a dead zone D where a cleaning liquid may not flow smoothly may be generated. However, in a case of the cleaning apparatus according to the present invention, the wafer supporting rod 120 injects a cleaning liquid in various directions, thereby preventing the dead zone D from facilitating the flow of the fluid and disturbing the flow of the cleaning liquid. Thus, the cleaning apparatus of the present invention enables uniform cleaning of the wafer 110 and prevents impurities from being absorbed to the wafer 110 again due to stagnation. In addition, the cleaning efficiency may be improved by applying megasonic by the megasonic oscillator 193 as described above.

Meanwhile, the cleaning liquid injected through the cleaning liquid injecting holes 121 and 122 may be identical to or different from a main cleaning liquid filled in the cleaning bath 111. In addition, the fluid injected through the cleaning liquid injecting holes 121 and 122 may be a gas and not a liquid. In this case, the cleaning liquid may flow smoothly in the cleaning bath 111 due to the injection of gas.

Now, a method for cleaning a wafer by using the wafer cleaning apparatus according to this embodiment configured as above will be described.

First, if a unit process for a wafer is completed, the wafer is mounted to a wafer supporting rod of the wafer cleaning apparatus configured as above. After that, if the wafer cleaning apparatus is operated, a cleaning liquid is supplied to the cleaning bath and contacts the surface of the wafer to start cleaning the wafer.

In the method of the present invention, the wafer is mounted to the rotatable wafer supporting rod, and a cleaning liquid is injected to the wafer to clean the wafer while rotating the wafer in a circumferential direction. At this time, the cleaning liquid is supplied through the cleaning liquid channel formed in the wafer supporting rod. In addition, the cleaning liquid is injected to the wafer through the cleaning liquid injecting holes formed in the surface of the wafer supporting rod. Further, megasonic may be applied to the wafer while the wafer is cleaned.

As described above, the cleaning liquid injecting hole is preferably formed between the slots formed in the wafer supporting rod. More preferably, the cleaning liquid injecting hole is formed in the slot of the wafer supporting rod to inject the cleaning liquid to the edge of the wafer.

In addition, the cleaning liquid injecting holes are preferably formed in a radial direction based on the cleaning liquid channel so that the cleaning liquid is injected in a radial direction.

Heretofore, this embodiment has been described based on the case where a semiconductor wafer is cleaned. However, this embodiment may also be applied to a general treatment process for treating a wafer with a treatment liquid such as an etching liquid as well as washing of a wafer. In this case, the above description may be applied identically if the term "cleaning" is replaced with "etching" or "treating".

In addition, though the above description is based on the case where a treatment liquid, in other words a liquid is used for treating a wafer, the present invention may also be applied to a case where a wafer is treated by using gas, without being limited to the above. In this case, the terms cleaning liquid" and "etching liquid" may be replaced with a general term "a treatment fluid".

Meanwhile, though it is illustrated in this embodiment that three wafer supporting rods 120 are installed at lower locations of the cleaning bath, the number and location of the wafer supporting rods 120 may be changed. In particular, in a case where the apparatus of this embodiment is used for etching accompanied with severe chemical reactions, a wafer supporting rod 120 may be additionally installed at the upper end of the wafer in order to prevent the wafers 110 from shaking and thus colliding with each other or floating above due to the flow of gas or etching liquid, generated by the severe chemical reactions. Further, as in the following embodiment, a plurality of wafer supporting rods 120 may be configured into a barrel form.

Figs. 8 to 12 are schematic views showing an apparatus for etching a wafer according to another embodiment of the present invention. In other words, the apparatus of this embodiment is particularly suitable for etching a wafer. However, the apparatus of this embodiment may also be applied when cleaning a wafer. The wafer etching apparatus of this embodiment will be described with reference to Figs. 8 to 11. The same reference symbol as in the former embodiment designates the same component with the same function as in the former embodiment, and thus such a component is not described in detail. The following description is focused on different points from the former embodiment.

The wafer etching apparatus of this embodiment includes an etching bath in which an etching liquid and a wafer 110 to be etched are received, a barrel 200 (see Fig. 9) for receiving the wafer 110, a circulating pump 191, an etching liquid temperature controller 194, and a diffusion plate 300. In other words, the wafer etching apparatus of this embodiment is different from the wafer cleaning apparatus of the former embodiment in the points that the wafer supporting rods 120 for supporting wafers are arranged above and below the wafers 110 in the form of a barrel 200 and that the diffusion plate 300 for diffusing the etching liquid supplied from a lower portion of the barrel 200 or supplied by circulation is provided.

The etching liquid used for etching a wafer in this embodiment may be an alkali solution such as NaOH and KOH, an acid such as fluoric acid (HF), nitric acid (HNO₃), acetate (CH₃COOH) and phosphoric acid (H₃PO₄), a mixed acid, fluoride (NH₄HF₂), nitrate (NH₄NO₃), or their fixtures. Chemical reactions occurring when etching a wafer are mostly exothermic reactions. For this reason, heat is significantly generated during the etching work, and the etching liquid may not be kept to have a constant temperature. The change of temperature and irregular temperature of the etching liquid may deteriorate the degree of flatness of the wafer. Therefore, it is preferred that the etching liquid supplied to the etching bath passes the etching liquid temperature controller 194 which may be a heat exchange or the like, so that the temperature of the etching liquid is kept constant. In addition, a filter 192 (see Fig. 1) for removing impurities may also be further provided as in the former embodiment.

Now, a barrel used for the wafer etching apparatus according to this embodiment will be described with reference to Fig. 9.

The barrel of this embodiment includes a plurality of wafer supporting rods 120, both side plates 201 and 202, and a rotating means.

The plurality of wafer supporting rods 120 (four wafer supporting rods in this embodiment along a periphery of the wafer 110) are disposed to be in parallel with each other. The wafer supporting rods 120 are rotatably fixed to both side plates 201 and 202. Detailed configuration of the wafer supporting rods 120, in other words the slots 124, the treatment fluid channel 123, the treatment fluid injecting holes 121 and 122 and so on, are basically identical to those of the former embodiment illustrated with reference to Figs. 3 to 6 and thus not described in detail here. Meanwhile, a reference symbol 126 on Fig. 9 designates a pipe for supplying a treatment fluid to the treatment fluid channel 123 of each wafer supporting rod 120.

Both side plates 201 and 202 have a plate shape and have holes into which both ends of the wafer supporting rod 120 may be rotatably inserted. The wafer supporting rod 120 is inserted and fixed to the holes of both side plates 201 and 202. Meanwhile, depending on the arrangement of the plurality of wafer supporting rods 120, the wafer 110 may not be easily mounted to the barrel 200. In this case, both side plates may be configured to open in right and left directions (in front and rear directions in Fig. 9) or separate in upper and lower directions. In other case, the locations of some wafer supporting rods 120 may be changed. In other words, for example, openings 203 are formed in both side plates 201 and 202 so that both side plates 201 and 202 may move with respect to one of four wafer supporting rods 120 (a wafer supporting rod located at a right upper side in Fig. 10), as shown in Fig. 10 that is a left side view of Fig. 9. Here, this wafer supporting rod 120 is moved to a lower position of the opening 203, and then the wafer is mounted. If all wafers are mounted, the wafer supporting rod is moved to an upper position of the opening again and fixed thereat. After that, the wafers may be put to an etching process.

The rotating means for rotating the wafer supporting rod 120 may include a motor 210, a power transmission unit 220 and gears 231 and 232, as shown in Fig. 9 for example. In other words, the motor 210 is mounted to one side plate 202, and the rotating force of the motor 210 is converted by using the power transmission unit 220 such as a bevel gear or a worm and a worm gear so that the rotating direction is changed to drive the central gear 231 rotatably fixed to the center of the side plate 202. In this case, the gears 232 engaged with the central gear 231 and coupled to the end of each wafer supporting rod 120 rotate in one direction so that the wafers 110 mounted to the slots 124 of each wafer supporting rod 120 rotate. Here, the rotating means is not limited to a configuration using gears, but it may be modified to various equivalent means such as a chain or a belt.

Meanwhile, while the etching process is performed by using the wafer etching apparatus of this embodiment, the barrel 200 may be oscillated up and down to promote more uniform etching. For this purpose, the wafer etching apparatus of this embodiment may include a barrel oscillating means connected to the upper portions of both side plates 201 and 202 to oscillate the barrel 200 up and down. In addition, in addition to or instead of the barrel oscillating means, the wafer etching apparatus of this embodiment may further include the megasonic oscillator 193 used in the former embodiment.

The wafer etching apparatus of this embodiment includes the diffusion plate 300 for diffusing and supplying the etching liquid supplied from the lower portion of the etching bath (or, supplied by circulation) to the upper portion of the etching bath. In addition, a gas supply pipe 320 and a flow rate control valve 321 are connected to the diffusion plate 300 to receive gas from the outside. In other words, the diffusion plate 300 plays a role of diffusing and emitting gas supplied from the outside as well as a role of diffusing the etching liquid supplied from the lower portion of the etching bath. The diffused and supplied gas facilitates smooth flow of the etching liquid and helps byproduct gas generated at the reactions between the etching liquid and the surface of the wafer 110 to be rapidly discharged above the etching bath. The diffused and supplied gas may be nitrogen or argon. In addition, on occasions, a gas giving influence on etching of a wafer may be used together with the etching liquid.

The diffusion plate 300 has a plate shape substantially identical to the plate shape of the etching bath. The diffusion plate 300 has an inner space defined by an upper surface, a lower surface and side surfaces. The diffusion plate 300 is preferably made of fluorine-based resin such as PVDF (poly(vinylidene fluoride)), PTFE (poly(tetrafluoroethylene)), and PFA (poly(fluoroalkoxy)).

In addition, the diffusion plate 300 has a plurality of through holes 311 formed through the upper and lower surfaces as shown in Figs. 11 and 12. The through holes 311 allows the etching liquid to pass Each through hole 311 has an inner wall so that the through hole 311 is isolated from the inner space of the diffusion plate 300. In addition, the diffusion plate 300 has a plurality of gas discharging holes 312 formed through only the upper surface in a region where the through holes 311 are not formed. The gas discharging holes 312 are communicated with the inner space of the diffusion plate 300. Thus, the etching liquid supplied from the lower portion of the etching bath is uniformly diffused and supplied to the upper portion through the through holes 311, and the gas supplied from the outside is uniformly supplied to the upper portion of the etching bath through the gas discharging holes 312. In particular, since the diffusion plate 300 of this embodiment includes both of the through holes 311 and the gas discharging holes 312, the wafer etching apparatus may be configured with a compact design in comparison to the structure having a plurality of diffusion plates as discloses Korean Laid-open Patent Publication No. 2003-0056702. In addition, since the through holes 311 and the gas discharging holes 312 do not interfere each other, it is possible to obtain wafers with uniform flatness.

Meanwhile, the size, shape and arrangement of the through holes 311 and the gas discharging holes 312 may be modified in various ways. For example, though Figs. 11 and 12 illustrate that the through holes 311 and the gas discharging holes 312 have the same size and shape, the size and shape of the through holes 311 and the gas discharging holes 312 may be changed depending on the distance from the gas supply pipe 320. In addition, the through holes 311 may have a sectional shape gradually narrowing from the lower position to the upper position. Further, though it is illustrated that the gas supply pipe 320 is connected to the diffusion plate 300 at one point in the side surface, the number of connections and the number of gas supply pipes 320 may be modified in various ways.

In addition, though the wafer etching apparatus of this embodiment includes the barrel shown in Figs. 9 and 10 and the diffusion plate 300 shown in Figs. 11 and 12 together, it is also possible that the present invention includes any one of them or any combination of such components. In other words, the wafer treatment apparatus may include non-barrier type wafer supporting rods 120 as in the former embodiment. In other cases, the wafer treatment apparatus may have a general barrel without the treatment fluid channel and the treatment fluid injecting hole in combination with the diffusion plate 300 of this embodiment. In other cases, the wafer treatment apparatus may include only the barrel 200 of this embodiment.

Moreover, similar to the former embodiment, this embodiment may also be applied to a general treatment process in which a wafer is treated with a treatment liquid such as cleaning as well as etching of a wafer. In addition, this embodiment may also be applied to a case where a wafer is treated using gas. In this case, the term "cleaning liquid" and "etching liquid" may be replaced with a general term "treatment fluid"

The present invention has been described in detain. However, it should be understood that the detailed description and specific examples, while indicating preferred embodiments of the invention, are given by way of illustration only, since various changes and modifications within the spirit and scope of the invention will become apparent to those skilled in the art from this detailed description.

### INDUSTRIAL APPLICABILITY

The present invention may be used for wet treatment such as cleaning and etching of a disk-type or plate-type object such as a semiconductor wafer or a substrate and any other objects with a shape.

## Claims

1. A fluid diffusion plate used in an apparatus for wet treatment of an object, the fluid diffusion plate comprising:
an inner space defined by an upper surface, a lower surface and side surfaces; a and
a fluid supply unit for supplying a treatment fluid to the inner space,
wherein a plurality of through holes are formed through the upper surface and the lower surface so that the through holes are isolated from the inner space by a barrier, and
wherein a plurality of fluid discharging holes communicated with the inner space through the upper surface are formed in a portion of the upper surface where the through holes are not formed.

2. A barrel, comprising:
a plurality of object supporting rods arranged in parallel with each other, a plurality of slots being formed in surfaces of the object supporting rods so that objects to be treated with a flat plate shape are mounted to stand thereon in a direction perpendicular to a length direction thereof;
both side plates for rotatably fixing both ends of the plurality of object supporting rods, respectively; and
a rotating means for rotating the object by rotating the object supporting rods,
wherein treatment fluid injecting holes for injecting a treatment fluid to the object and treatment fluid channels for supplying the treatment fluid to the treatment fluid injecting holes are formed in the object supporting rods.

3. The barrel according to claim 2, wherein the treatment fluid injecting holes include first treatment fluid injecting holes formed between the slots to inject a treatment fluid to a surface of the object.

4. The barrel according to claim 3, wherein the treatment fluid injecting holes include second treatment fluid injecting holes formed at the slots to inject a treatment fluid to an edge of the object.

5. The barrel according to claim 2,
wherein the treatment fluid channels are formed in the object supporting rods, and
wherein the treatment fluid injecting holes are formed in a radial direction based on the treatment fluid channels to inject a treatment fluid in a radial direction.

6. The barrel according to claim 5,
wherein the treatment fluid channels are defined by outer walls of the treatment fluid channels which are partially opened, and
wherein any one between the outer walls of the treatment fluid channels and a region of the object supporting rods other than the outer walls of the treatment fluid channels are fixed and the other thereof are rotatable,

7. An apparatus for wet treatment of an object, comprising:
a treatment bath in which an object to be treated is received and treated;
an object supporting means for receiving and supporting the object to be treated;
a treatment fluid supplying means for supplying a treatment fluid from a location below the treatment bath; and
a fluid diffusion plate defined in claim 1, which is disposed between the object supporting means and the treatment fluid supplying means.

8. The apparatus for wet treatment of an object according to claim 7, wherein the object to be treated is an article with a flat plate shape.

9. The apparatus for wet treatment of an object according to claim 8,
wherein the object to be treated is a water, and
wherein the object supporting means is a supporting rod having a plurality of slots formed in a surface thereof to support the wafer so that the wafer stands in a direction perpendicular to a bottom surface of the treatment bath.

10. The apparatus for wet treatment of an object according to claim 9,
wherein the supporting rod is rotatably installed in the treatment bath, and
wherein the apparatus comprises a rotating means connected to the supporting rod to rotate the wafer in a circumferential direction by rotating the rotating rod.

11. The apparatus for wet treatment of an object according to claim 9 or 10, wherein a plurality of the support rods are disposed along a periphery of the wafer in parallel with each other to configure a barrel.

12. The apparatus for wet treatment of an object according to claim 11, further comprising a barrel oscillating means for oscillating the barrel vertically in the treatment bath.

13. The apparatus for wet treatment of an object according to claim 7, further comprising a megasonic oscillator for applying megasonic to the object to be treated.

14. The apparatus for wet treatment of an object according to claim 7,
wherein the object to be treated is an article with a flat plate shape, and
wherein the object supporting means is a barrel defined in any one of the claims 2 to 6.

15. An apparatus for wet treatment of an object, comprising:
a treatment bath in which an object to be treated is received and treated;
a barrel defined in any one of claims 2 to 6 and serving as an object supporting means for receiving and supporting the object to be treated; and
a treatment liquid supplying means for supplying a treatment liquid from a lower portion of the treatment bath.

16. An apparatus for wet treatment of a wafer, comprising:
a treatment bath in which a wafer to be treated is received and treated;
a plurality of wafer supporting rods rotatably installed the treatment bath and having a plurality of slots formed in surfaces thereof to support a wafer so that the wafer stands in a direction perpendicular to a bottom surface of the treatment bath; and
a rotating means connected to the wafer supporting rods to rotate the wafer in a circumferential direction by rotating the wafer supporting rods,
wherein treatment fluid injecting holes for injecting a treatment fluid to the wafer and treatment fluid channels for supplying the treatment fluid to the treatment fluid injecting holes are formed in the wafer supporting rods.

17. The apparatus for wet treatment of a wafer according to claim 16, wherein the treatment fluid injecting holes include first treatment fluid injecting holes formed between the slots to inject a treatment fluid to a surface of the wafer.

18. The apparatus for wet treatment of a wafer according to claim 17, wherein the treatment fluid injecting holes include second treatment fluid injecting holes formed at the slots to inject a treatment fluid to an edge of the wafer.

19. The apparatus for wet treatment of a wafer according to claim 16,
wherein the treatment fluid channels are formed in the wafer supporting rods, and
wherein the treatment fluid injecting holes are formed in a radial direction based on the treatment fluid channels to inject a treatment fluid in a radial direction.

20. The apparatus for wet treatment of a wafer according to claim 19,
wherein the treatment fluid channels are defined by outer walls of the treatment fluid channels which are partially opened, and
wherein any one between the outer walls of the treatment fluid channels and a region of the wafer supporting rods other than the outer walls of the treatment fluid channels is fixed and the other thereof is rotatable.

21. The apparatus for wet treatment of a wafer according to claim 16, further comprising a megasonic oscillator for applying megasonic to the wafer.

22. The apparatus for wet treatment of a wafer according to claim 16,
wherein the plurality of wafer supporting rods are disposed along a periphery of the wafer in parallel with each other to configure a barrel.

23. The apparatus for wet treatment of a wafer according to claims 22, further comprising a barrel oscillating means for oscillating the barrel vertically in the treatment bath.

24. A method for wet treatment of an object in a treatment bath, wherein a treatment liquid and a treatment fluid are diffused below the object in the treatment bath and then supplied, so that the flow of the diffusing treatment liquid is not interfering with the flow of the diffusing treatment fluid.

25. The method for wet treatment of an object in a treatment bath according to claim 24,
wherein the object to be treated is a wafer, and
wherein a plurality of wafers are treated while stranding vertically on a bottom surface of the treatment bath.

26. The method for wet treatment of an object in a treatment bath according to claim 25, wherein the wafer is treated while the wafer is rotated in a circumferential direction.

27. The method for wet treatment of an object in a treatment bath according to claim 24, wherein megasonic is applied to the object while the object is being treated.

28. The method for wet treatment of an object in a treatment bath according to claim 24, wherein the object to be treated is oscillated vertically while the object is being treated.

29. A method for wet treatment of a wafer, comprising:
mounting a plurality of wafers to a plurality of wafer supporting rods which are rotatable and are disposed in parallel with each other in a treatment bath so that the wafers are parallel with each other in a length direction of the wafer supporting rods.; and
injecting a treatment fluid to the wafers while rotating the wafers in a circumferential direction by rotating the wafer supporting rods so that the wafers are treated,
wherein, in the step of treating the wafers, the treatment fluid is supplied through treatment fluid channels formed in the wafer supporting rods, and the treatment fluid is injected to the wafers through treatment fluid injecting holes formed in surfaces of the wafer supporting rods.

30. The method for wet treatment of a wafer according to claim 29, wherein the treatment fluid injecting holes are formed between slots formed in the wafer supporting rods so that the treatment fluid is injected to surfaces of the wafers.

31. The method for wet treatment of a wafer according to claim 30, wherein the treatment fluid injecting holes are formed also in the slots of the wafer supporting rods so that the treatment fluid is injected even to the edges of the wafers.

32. The method for wet treatment of a wafer according to claim 29, wherein the treatment fluid injecting holes are formed in a radial direction based on the treatment fluid channels so that the treatment fluid is injected in a radial direction.

33. The method for wet treatment of a wafer according to claim 29, wherein megasonic is applied to the wafers while the wafers are being treated.

34. The method for wet treatment of a wafer according to claim 29, further comprising:
diffusing and supplying the treatment fluid from a location below the wafer supporting rods into the treatment bath.

35. The method for wet treatment of a wafer according to claim 34, wherein, while the wafers are treated, gas is discharged toward the wafers so as not to interfere with the flow of the diffusing treatment fluid.

36. The method for wet treatment of a wafer according to claim 29, wherein the plurality of wafer supporting rods are oscillated vertically while the wafers are being treated.
